# EUROPEAN PATENT APPLICATION

(11) **EP 4 297 061 A1**
(43) Date of publication of application: **27.12.2023**
(21) Application number: 21940569.3
(22) Date of filing: 14.12.2021
(51) Int. Cl.: H01J 27/18, H01J 37/08, H05H 1/46

(54) **ION SOURCE APPARATUS WITH ADJUSTABLE PLASMA DENSITY**

(30) Priority: 18.05.2021 CN 202110541749
(71) Applicant: Jiangsu Leuven Instruments Co. Ltd, Xuzhou, Jiangsu 221300 (CN)
(72) Inventor: ZHANG, Yaoyao, Xuzhou, Jiangsu 221300 (CN); LIU, Xiaobo, Xuzhou, Jiangsu 221300 (CN); HU, Dongdong, Xuzhou, Jiangsu 221300 (CN); ZHANG, Huaidong, Xuzhou, Jiangsu 221300 (CN); LIU, Haiyang, Xuzhou, Jiangsu 221300 (CN); LI, Xiaolei, Xuzhou, Jiangsu 221300 (CN); LI, Na, Xuzhou, Jiangsu 221300 (CN); GUO, Song, Xuzhou, Jiangsu 221300 (CN); XU, Kaidong, Xuzhou, Jiangsu 221300 (CN)
(74) Representative: von Tietzen und Hennig, Nikolaus
(86) International application number: PCT/CN2021/137792
(87) International publication number: WO 2022/242126

(57) **Abstract**

An ion source apparatus with an adjustable plasma density, which belongs to the field of semiconductor devices. A coil is wound on the outer side of a discharge cavity of the ion source device having an adjustable plasma density; a radio frequency module is connected to the coil; an air intake pipe passes through an ion source chamber and is in communication with the discharge cavity; the ion source chamber and the discharge cavity are provided with grids on open end face sides in the same direction; and the discharge cavity is composed of a large-diameter section discharge cavity and a small-diameter section discharge cavity that have non-uniform diameters, wherein the large-diameter section discharge cavity is in communication with the small-diameter section discharge cavity, one end face of the large-diameter section discharge cavity being an open end face, and the open end face facing the grids. Coils at different positions are used, such that a middle area and a marginal area of a wafer can be bombarded separately and integrally, thereby adjusting the plasma density distribution of a discharge cavity, and ensuring the etching uniformity thereof.

## Description

### CROSS-REFERENCE TO RELATED APPLICATION

This application claims priority to Chinese patent application NO. 2021105417497 filed on May 18, 2021 and entitled "ION SOURCE APPARATUS WITH ADJUSTABLE PLASMA DENSITY", the disclosure of which is hereby incorporated by reference in its entirety.

### TECHNICAL FIELD

The present invention relates to the technical field of semiconductor devices, and in particular to an ion source apparatus with an adjustable plasma density.

### BACKGROUND

An ion source is a device that ionizes neutral atoms or molecules and extracts ion beams from them. The ion source is an indispensable component of the devices such as various types of ion accelerators, mass spectrometers, electromagnetic isotope separators, ion implantation machines, ion beam etching devices, ion thrusters, and neutral beam injectors in controlled fusion devices.

Radio-frequency inductively coupled plasma (RFICP) sources develops rapidly in recent years due to the advantages such as their simple structure, ability to produce highdensity pure plasmas, long service life, and good cost-effectiveness. The currently used radio frequency inductively coupled plasma sources are mainly cylindrical, with the radio frequency coil of the radio frequency inductively coupled plasma source wound outside the electrically insulated quartz discharge cavity. In the case where the radio frequency power is applied to the coil through a matching network, the radio frequency current passes through the coil, thus generating radio frequency magnetic flux and an radio frequency electric field is induced along the axis of the discharge cavity, and the electrons therein are accelerated by the electric field to generate plasmas. At the same time, the energy of the coil is coupled to the plasmas.

The ion source chamber and discharge cavity in the existing ion source device or the ion source quartz cavity structure are mutually integrated structures, and coils are arranged on the outer wall of the discharge cavity. Since the radio frequency inductively coupled plasma source is cylindrical, when the radio frequency power supply is loaded on the radio frequency coil, due to the skin effect of the current, the current mainly flows through the discharge cavity wall and gradually decays within the skin layer. Therefore, the plasma density in the discharge cavity generally exhibits a trend of high on both sides and low in the middle. Due to the influence of the radio frequency power and the working pressure, the plasma density distribution in the discharge cavity also exhibits a saddle-shaped trend. Due to the nonuniform distribution of the plasma density, the etching rate is nonuniform, which affects the etching uniformity.

### SUMMARY

The exemplary embodiments of the present invention provide an ion source apparatus with an adjustable plasma density, which adjusts the plasma density in multiple stages to improve etching uniformity.

The exemplary embodiments of the present invention provide an ion source apparatus with an adjustable plasma density. The ion source apparatus comprises an ion source chamber and a radio frequency module. The ion source chamber is provided with a discharge cavity, and a coil is wound on an out side of the discharge cavity; and the radio frequency module is connected with the coil. A gas inlet pipeline passes through the ion source chamber and is in communication with the discharge cavity, the ion source chamber and the discharge cavity are provided with grids on open terminal face sides in the same direction.

The discharge cavity is a convex cavity structure composed of a large-diameter section discharge cavity and a small-diameter section discharge cavity. The large-diameter section discharge cavity is in communication with the small-diameter section discharge cavity and central axes of the large-diameter section discharge cavity and the small-diameter section discharge cavity remain consistent with each other. The one terminal face of the large-diameter section discharge cavity is an open terminal face, and the open terminal face faces the grids.

In one embodiment, the coil wound on the out side of the discharge cavity includes a first coil and a second coil. The first coil is wound around a closed bottom terminal face of the large-diameter section discharge cavity; and the second coil is wound around an outer wall of the small-diameter section discharge cavity.

In one embodiment, a winding diameter of the first coil is greater than a winding diameter of the second coil.

In one embodiment, the first coil is a double-layer planar coil, and an axial gap L is provided between the first coil and the closed bottom terminal face of the large-diameter section discharge cavity. A value for the axial gap L ranges from 2 mm to 20 mm.

In one embodiment, the second coil is a double-layer spiral coil, and a radial gap R is provided between the second coil and the outer wall of a cylinder body of the small-diameter section discharge cavity. A value for the radial gap R ranges from 2 mm to 20 mm.

In one embodiment, an inner diameter of the small-diameter section discharge cavity is 1/4 to 1/2 of an inner diameter of the large-diameter section discharge cavity.

In one embodiment, the radio frequency module includes at least one radio frequency column located on the ion source chamber, a radio frequency power supply and a radio frequency matcher. The radio frequency power supply is connected to the radio frequency matcher, the radio frequency matcher is connected to a power distribution module, and the power distribution module is connected to the first coil and the second coil respectively through the radio frequency column. The power distribution module is configured to allocate powers of the first coil and the second coil.

In one embodiment, the at least one radio frequency column is located at a closed terminal part of the ion source chamber; and the at least one radio frequency column passes through the closed terminal part of the ion source chamber.

In one embodiment, a distribution rate r of the power distribution module is r=P1:P2; where P1 represents a radio frequency power entering the first coil, P2 represents a radio frequency power entering the second coil, and the distribution rate r ranges from 1:20 to 20: 1.

In one embodiment, the grids are provided with two layers, and the two layers of the grids are respectively connected with an input terminal of a filter through the radio frequency column, and the input terminal of the filter is connected to an alternating current power supply.

The present invention has the following beneficial effects.

The ion source apparatus with the adjustable plasma density according to the present invention adopts coils at different positions, such that a middle area and a marginal area of a wafer can be bombarded separately and integrally, thereby adjusting the plasma density distribution of a discharge cavity, and ensuring the etching uniformity thereof.

The coil at the small-diameter terminal of the discharge cavity of the ion source apparatus with the adjustable plasma density according to the present invention is adopted alone or is allocated with high power, such that the plasma density distribution in the middle area can be adjusted, which is suitable for the situations with low plasma density in the middle area.

The coil at the large-diameter terminal of the discharge cavity of the ion source apparatus with the adjustable plasma density according to the present invention is adopted alone or is allocated with high power, such that the plasma density distribution in the marginal area can be adjusted, which is suitable for the situations with low plasma density in the marginal area.

### BRIEF DESCRIPTION OF THE DRAWINGS

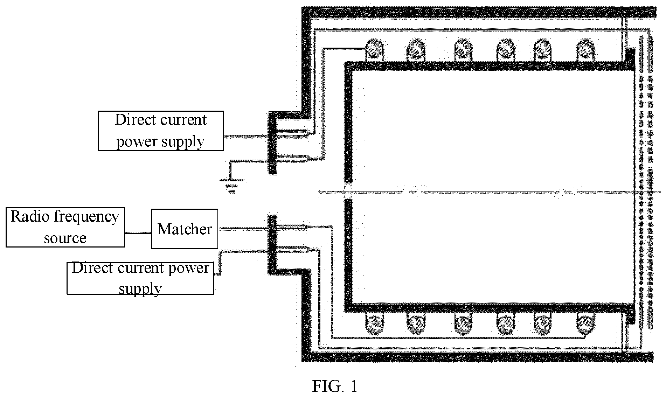

FIG. 1 illustrates a structure schematic diagram of the prior art.

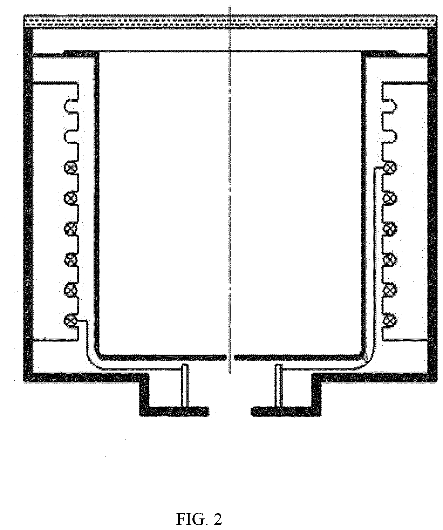

FIG. 2 illustrates a structure schematic diagram of an ion quartz source cavity in the prior art.
FIG. 3 illustrate a structure schematic diagram of the ion source apparatus in one embodiment of the present invention.
FIG. 4 illustrates a three-dimensional schematic diagram of a discharge cavity structure in one embodiment of the present invention.
FIG. 5 illustrates a cross-sectional schematic diagram of the discharge cavity structure in one embodiment of the present invention.
FIG. 6 illustrates a three-dimensional structure schematic diagram of a coil winding in one embodiment of the present invention.
FIG. 7 illustrates a three-dimensional structure schematic diagram of the coil winding and the discharge cavity in one embodiment of the present invention.
FIG. 8 illustrates a cross-sectional structure schematic diagram of FIG. 7 of the present invention.

Descriptions of reference numerals are as follows.

1. First gird; 2. Second grid; 3. Discharge cavity; 4. First coil; 5. Second coil; 6. Power distribution module; 7. Radio frequency matcher; 8. Radio frequency matcher; 9. Gas inlet pipeline; 12. First radio frequency column; 13. Second radio frequency column; 14. Closed terminal part of ion source chamber; 15. Ion source chamber; 10. First alternating current power supply; 101. Second alternating current power supply; 121. Radio frequency column; 31. Large-diameter section discharge cavity; 32. Small-diameter section discharge cavity.

### DETAILED DESCRIPTION OF THE EMBODIMENTS

In order to enable the objectives and the technical solutions of the embodiments of the present invention to be more clearer, the technical solution of the present invention will be clearly and completely clarified below in conjunction with the accompanying drawings of the embodiments. Obviously, the clarified embodiments is a part of the embodiments of the present invention and not to be all the embodiments. Based on the embodiments of the present invention, all other embodiments obtained by a person skilled in the art without making inventive labor all fall within the protection scope of the present invention.

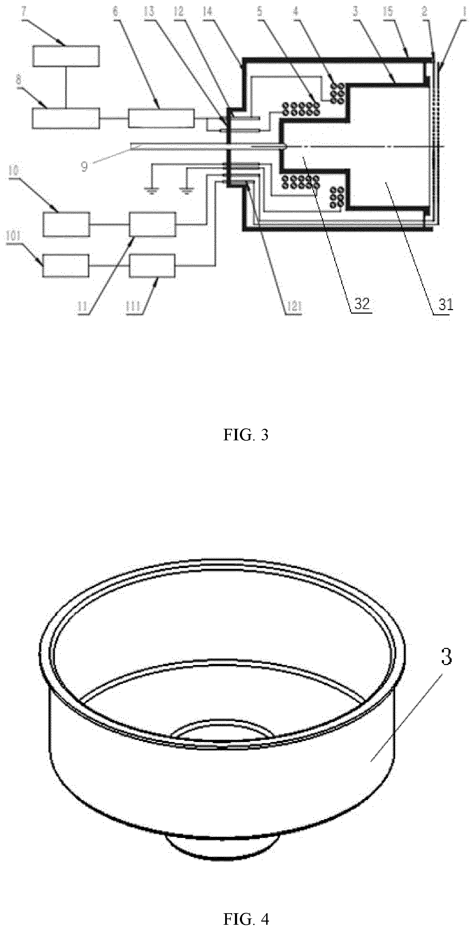

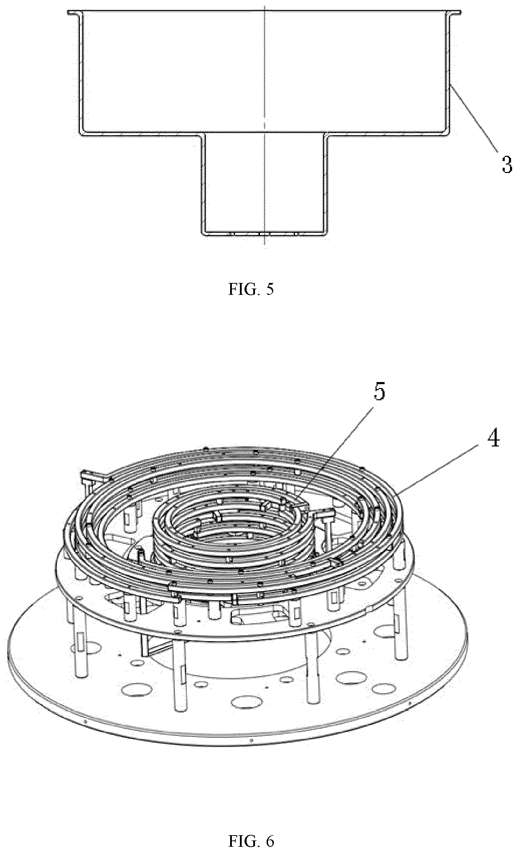

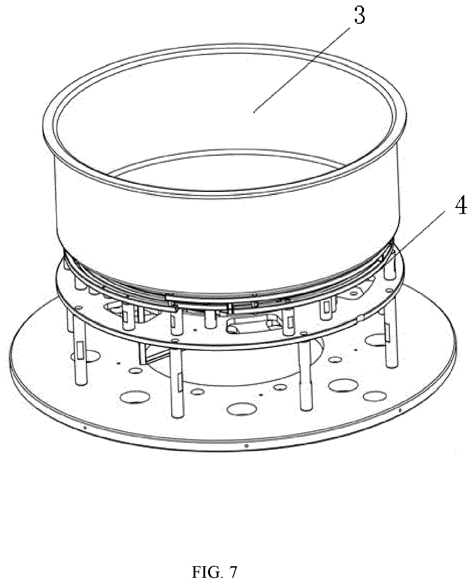

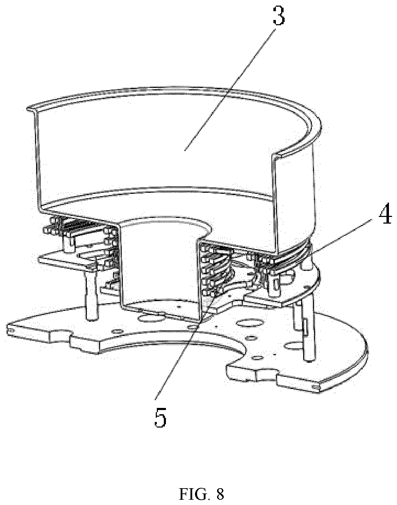

As illustrated in FIG. 3, FIG 4, FIG.5, FIG.6, FIG. 7 and FIG. 8, the exemplary embodiments of the present invention provide an ion source apparatus with an adjustable plasma density, which includes an ion source chamber 15 and a radio frequency module. The ion source chamber 15 is provided with a discharge cavity 3 and a coil is wound on an out side of the discharge cavity 3; and the radio frequency module is connected with the coil. A gas inlet pipeline 9 passes through the ion source chamber 15 and is in communication with discharge cavity 3, the ion source chamber 15 and the discharge cavity 3 are provided with grids on open terminal face sides in the same direction. The grids are provided with two layers, that is the first gird 1 and the second gird 2, and the two layers of the grids are respectively connected to an input terminal of a filter through the radio frequency column, and the input terminal of the filter is connected to an alternating current power supply.

The advantages of this solution are as follows. The discharge cavity 3 is a convex cavity structure composed of a large-diameter section discharge cavity 31 and a small-diameter section discharge cavity 32. The large-diameter section discharge cavity 31 is in communication with the small-diameter section discharge cavity 32 and central axes of the large-diameter section discharge cavity 31 and the small-diameter section discharge cavity 32 remain consistent with each other. The one terminal face of the large-diameter section discharge cavity 31 is an open terminal face, and one terminal face of the large-diameter section discharge cavity faces the first grid 1 and the second grid 2. By using the large-diameter section discharge cavity 31 and the small-diameter section discharge cavity 32, different areas of a wafer surface can be bombarded, thereby ensuring the uniformity of the bombardments and the etching uniformity thereof.

The closed terminal part 14 of the ion source chamber is provided with at least one radio frequency column 121, the radio frequency power supply is connected to the radio frequency matcher, the radio frequency matcher 8 is connected to the power distribution module 6, and the power distribution module is connected to the first coil 4 and the second coil 5 through the at least one radio frequency column. The radio frequency column is divided into the first radio frequency column 12, the second radio frequency column 13, and the third radio frequency column 121. The first radio frequency column 12 is connected to the first coil 4, the second radio frequency column 13 is connected to the second coil 5, and the power distribution module 6 allocates the powers of the first coil 4 and the second coil 5 through the first radio frequency column 12 and the second radio frequency column 13. The coil that wound on the outer side of the discharge cavity is composed of the first coil 4 and the second coil 5. The first coil 4 is wound around the bottom terminal of the large-diameter section discharge cavity 31, and the second coil 5 is wound around the outer wall of the small-diameter section discharge cavity 32. The first coil 4 is a double-layer planar coil, and an axial gap L that ranges from 2 mm to 20 mm is provided between the first coil 4 and the bottom terminal of the large-diameter section discharge cavity 31. The second coil 5 is a double-layer spiral coil, and a radial gap R that ranges from 2 mm to 20 mm is provided between the second coil 5 and the outer wall of the small-diameter section discharge cavity 32. The radio frequency module is composed of the power distribution module 6, the radio frequency power supply 7, and the radio frequency matcher 8. At least one radio frquency column, the radio frequency power supply 7 and the radio frequency matcher 8 are arranged on the ion source chamber 15. The radio frequency power supply 7 is connected to the radio frequency matcher 8. The radio frequency matcher 8 is connected to the power distribution module 6. The power distribution module 6 is connected to the first coil 4 and the second coil 5 respectively through the radio frequency column. The power distribution module 6 is configured to allocate the powers of the first coil 4 and the second coil 5. The advantages of this solution are as follows. A separate control system is established by using at least one independent radio frequency column to connect to other control modules respectively, which can be independently controlled for different components. In the case where a fault appears, it can be replaced or overhauled separately, thereby reducing the maintenance time and the operating costs.

The power distribution module 6 can allocate the radio frequency power entering the first coil 4 and the second coil 5, and by adjusting the distribution rate r, the adjustments of plasma density distributions in the discharge cavity can be implemented. The distribution rate r is r=P1:P2, where P1 represents the radio frequency power entering the first coil, P2 represents the radio frequency power entering the second coil and the distribution rate r ranges from 1:20 to 20:1. The advantages of this solution are as follows. Different powers are set to the first coil 4 and the second coil 5 through the power distribution module 6, which can implement ion density control in actual processing technology. The coil at the large-diameter terminal of the discharge cavity is adopted alone or is allocated with high power, such that the plasma density distribution in the marginal area can be adjusted, which is suitable for the situations with a low plasma density in the marginal area, further ensuring the uniformity of ion bombardment areas and the etching uniformity thereof.

In the above solutions, the spiral coil and the planar coil are adopted in the first coil 4 and the second coil 5, and a two-stage structure is adopted in the discharge cavity. Different power are loaded to the two coils to correct the plasma density in the discharge cavity, enabling the plasma density in the discharge cavity trend to be uniform, which is conducive to improving the etching uniformity.

As a preferred solution for the ion source apparatus with the adjustable plasma density of the present invention, the inner diameter of the small-diameter section discharge cavity 32 is 1/4 to 1/2 of the inner diameter of the large-diameter section discharge cavity 31. The small-diameter section discharge cavity 32 is adjusted proportionally according to the size of the large-diameter section discharge cavity 31, which satisfies the etching process requirements and facilitates the processing and the molding.

The processing technology based on the ion source device with adjustable plasma density provided by the present invention lies in the following.

When the etching is required, the first alternating current power supply 10, the second alternating current power supply 101, the first filter 11, and the first filter 111 are started, and the first alternating current power supply 10 and the second alternating current power supply 101 are started to connect to the first filter 11 and the first filter 111 respectively. The first filter 11 and the first filter 111 are connected to the first grid 1 and the second grid 2 through the independent third radio frequency column 121.

Plasma gas such as Ar and O₂ enters the discharge cavity 3 through the gas inlet pipeline 9, and under the actions of the first coil 4 and the second coil 5, the gas in the discharge cavity 3 is ionized to generate plasmas. After the plasmas in the discharge cavity 3 are extracted through the first grid 1 and the second grid 2, the plasmas bombard the target materials in the form of the ion beams to etch the wafer.

Beyond the skin depth, the plasma density gradually decreases. It is found by the experiments that when the discharge cavity is relatively large, the spiral coil has relatively small effects on adjusting the plasma density in the middle area, making it difficult to adjust the plasma density uniformly. However, the planar coil has good effects on adjusting the density in the middle area. Therefore, a two-stage discharge cavity is adopted, with the spiral coil in the small-diameter area and the planar coil in the large-diameter area, which is more conducive to adjusting the plasma density and making the plasma density distribution uniform.

The above is only the preferred specific implementations of the present invention. However, the present invention is not limited thereto. Any variations or replacements that can be easily conceived of by a person skilled in the art within the technical scope disclosed by the present invention all fall within the protection scope of the present invention. Therefore, the protection scope of the present invention should be based on the protection scope of claims.

## Claims

1. An ion source apparatus with an adjustable plasma density, comprising:
an ion source chamber (15), provided with a discharge cavity (3), wherein a coil is wound on an out side of the discharge cavity (3); and
a radio frequency module, connected with the coil;
wherein a gas inlet pipeline (9) passes through the ion source chamber (15) and is in communication with the discharge cavity (3), the ion source chamber (15) and the discharge cavity (3) are provided with grids (1, 2) on open terminal face sides in a same direction, and
the discharge cavity (3) is a convex cavity structure composed of a large-diameter section discharge cavity (31) and a small-diameter section discharge cavity (32); and the large-diameter section discharge cavity (31) is in communication with the small-diameter section discharge cavity (32) and central axes of the large-diameter section discharge cavity (31) and the small-diameter section discharge cavity (32) remain consistent with each other; and
one terminal face of the large-diameter section discharge cavity (31) is an open terminal face, and the open terminal face faces the grids (1, 2).

2. The apparatus according to claim 1, **characterized in that** the coil wound on the out side of the discharge cavity (3) includes a first coil (4) and a second coil (5); the first coil (4) is wound around a closed bottom terminal face of the large-diameter section discharge cavity (31); and the second coil (5) is wound around an outer wall of the small-diameter section discharge cavity (32).

3. The apparatus according to claim 2, **characterized in that** a winding diameter of the first coil (4) is greater than a winding diameter of the second coil (5).

4. The apparatus according to claim 2, **characterized in that** the first coil (4) is a double-layer planar coil, and an axial gap L is provided between the first coil (4) and the closed bottom terminal face of the large-diameter section discharge cavity (31), wherein a value for the axial gap L ranges from 2 mm to 20 mm.

5. The apparatus according to claim 2, **characterized in that** the second coil (5) is a double-layer spiral coil, and a radial gap R is provided between the second coil (5) and the outer wall of a cylinder body of the small-diameter section discharge cavity, wherein a value for the radial gap R ranges from 2 mm to 20 mm.

6. The apparatus according to claim 1, **characterized in that** an inner diameter of the small-diameter section discharge cavity (32) is 1/4 to 1/2 of an inner diameter of the large-diameter section discharge cavity.

7. The apparatus according to any one of claims 2 to 6, **characterized in that** the radio frequency module includes at least one radio frequency column located on the ion source chamber (15), a radio frequency power supply (7) and a radio frequency matcher (8), the radio frequency power supply (7) is connected to the radio frequency matcher (8), the radio frequency matcher (8) is connected to a power distribution module (6), and the power distribution module (6) is connected to the first coil (4) and the second coil (5) respectively through the radio frequency column; and the power distribution module (6) is configured to allocate powers of the first coil (4) and the second coil (5).

8. The apparatus according to claim 7, **characterized in that** the at least one radio frequency column is located at a closed terminal part of the ion source chamber (15); and the at least one radio frequency column passes through the closed terminal part of the ion source chamber (15).

9. The apparatus according to claim 7, **characterized in that** a distribution rate r of the power distribution module (6) is r=P1:P2; where P1 represents a radio frequency power entering the first coil (4), P2 represents a radio frequency power entering the second coil (5), and the distribution rate r ranges from 1:20 to 20: 1.

10. The apparatus according to claim 7, **characterized in that** the grids (1, 2) are provided with two layers, and the two layers of the grids (1, 2) are respectively connected with an input terminal of a filter through the radio frequency column, and the input terminal of the filter is connected to an alternating current power supply.
